# EUROPEAN PATENT APPLICATION

(11) **EP 1 337 134 A2**
(43) Date of publication of application: **20.08.2003**
(21) Application number: 03250776.6
(22) Date of filing: 07.02.2003
(51) Int. Cl.: H05K 1/11, H05K 3/34, H01L 23/498

(54) **Terminal structure having large peel strength of land portion and ball**

(30) Priority: 14.02.2002 JP 2002037082
(71) Applicant: ALPS ELECTRIC CO., LTD., Ota-ku Tokyo 145 (JP)
(72) Inventor: Hirose, Yoshitaka, c/o Alps Electric Co., Ltd., Tokyo (US)
(74) Representative: Kensett, John Hinton

(57) **Abstract**

The present invention intends to provide a terminal structure strong in the peel strength of a land portion and a ball. In a terminal structure according to the invention, a land portion (2) includes a terminal portion for soldering a ball (7) ; a support portion (4) disposed in the neighborhood of an outer periphery portion of the terminal portion; and a link portion (5) for linking the terminal portion and the support portion; and wherein on a base material, with an entirety of the terminal portion including an edge portion located in the outer periphery portion of the terminal portion exposed, an insulating layer (6) is disposed so as to cover the support portion; and with a solder straddled a surface and an edge portion of the terminal portion, the ball is soldered to the terminal portion. Accordingly, the terminal structure that is large in the peel strength of the ball from the terminal portion and of the terminal portion from the base material can be obtained.

## Description

### BACKGROUND OF THE INVENTION

### 1. Field of the Invention

The present invention relates to a terminal structure preferably used in various kinds of electronic instruments, or electronic units.

### 2. Description of the Related Art

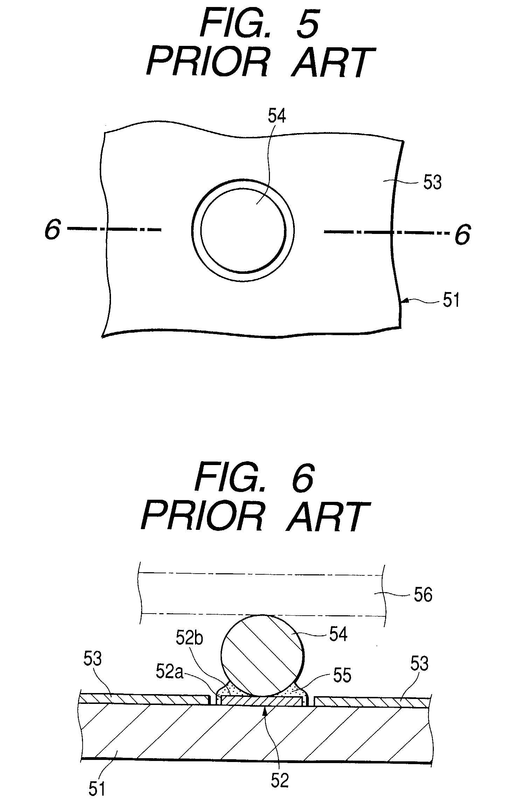

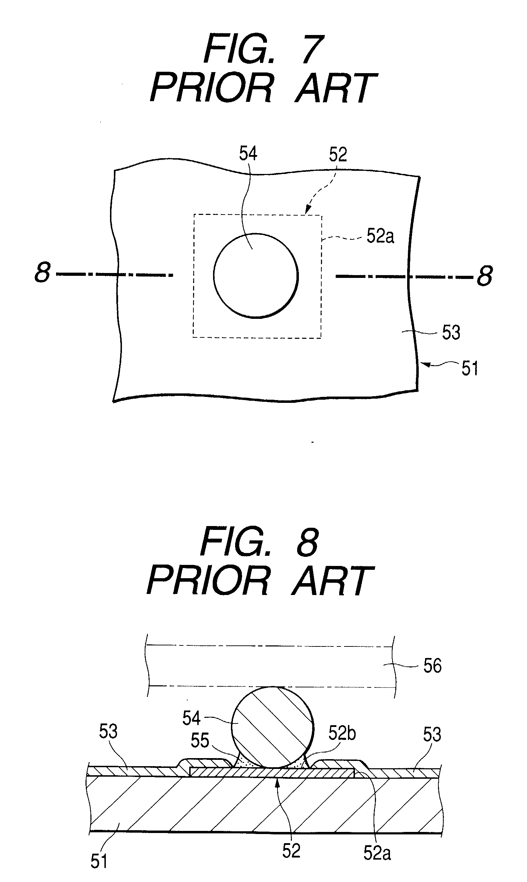

Drawings of existing terminal structures will be explained. Fig. 5 is an enlarged plan view of an essential portion showing a first existing example of an existing terminal structure, Fig. 6 is an enlarged sectional view in a 6-6 line of Fig. 5, Fig. 7 is an enlarged plan view of an essential portion showing a second existing example of the existing terminal structure, and Fig. 8 is an enlarged sectional view in a 8-8 line of Fig. 7.

Next, a configuration of the first existing example of the existing terminal structure will be explained with reference to Figs. 5 and 6. Not shown in the drawings, in a base material 51 that is made of a multi-layered substrate in which insulating thin plates are laminated or the like, on a surface and in inner layers thereof, a wiring pattern formed of a conductive pattern is formed and various electric components are soldered to the wiring pattern, and thereby a desired electronic circuit is formed.

Furthermore, on one surface of the base material 51, a circular land portion 52 made of a conductive pattern is disposed, and the land portion 52 is connected through a connecting conductor (not shown in the drawing) such as a through hole to the wiring pattern.

Furthermore, on one surface of the base material 51, with an entire land portion 52 including an edge portion 52a located at an outer periphery portion of the land portion 52 exposed, an insulating layer 53 that is made of an insulating resist is formed.

A metallic ball 54 to be used for a terminal has a solder film (not shown in the drawing) formed on a surface thereof. The solder ball 54 disposed on the exposed land portion 52 is attached to the land portion 52 with solder 55.

At this time, the solder 55 is adhered to the edge portion 52a and a surface 52b of the land portion 52.

In the terminal structure thus configured, as shown in Fig. 6, on the ball 54, a member to be connected 56 made of such as a mother board or an IC element is disposed and soldered to the ball 54, and thereby an electrical connection is established.

However, in the first existing example thus configured, there is a problem in that when the peel test of the ball 54 is performed with an external force applying on the ball 54, the land portion 52 adhered through the solder 55 to the ball 54 peels easily from the base material 51 together with the ball 54.

In order to overcome the problem, in a second existing example shown in Figs. 7 and 8, the land portion 52 is configured so that an outer periphery portion thereof including the edge portion 52a may be covered with an insulating layer 53 and a surface 52b of a center portion may be exposed from the insulating layer 53.

The ball 54 is adhered to the exposed surface 52b with the solder 55.

Other configurations are similar to the first existing example, the same components are given the same reference numerals, and explanations thereof will be omitted.

Furthermore, in the second existing example thus configured, when the peel test is performed by applying an external force on the ball 54, since the outer periphery portion of the land portion 52 is supported by the insulating layer 53, the land portion 52 does not peel off the base material 51. However, there is a problem in that the ball 54, together with the solder 55, peels easily from the land portion 52.

In the existing terminal structures, there are problems in that in the first existing example, the land portion 52 and the ball 54 easily peel off the base material 51, and in the second existing example, the ball 54 and the solder 55 easily peel off the land portion 52.

The object of the present invention is to provide a terminal structure that is large in the peel strength of a land portion and a ball.

### SUMMARY OF THE INVENTION

According to the present invention a terminal structure is configured so that the terminal structure includes a base material having a land portion made of a conductive pattern; and a metallic ball that is soldered onto the land portion and used as a terminal; wherein the land portion includes a terminal portion for soldering the ball; a support portion disposed in the neighborhood of an outer periphery portion of the terminal portion; and a link portion that links the terminal portion and the support portion; and wherein on the base material, in a state where an entirety of the terminal portion including an edge portion located at the outer periphery portion of the terminal portion is exposed, an insulating layer is disposed so as to cover the support portion; and in a state where the solder straddles a surface and the edge portion of the terminal portion, the ball is soldered to the terminal portion.

Furthermore, the link portion may be configured so as to be disposed plurally in the outer periphery portion of the terminal portion.

The support portion may be configured so as to surround the outer periphery portion of the terminal portion.

A plurality of the link portions may be disposed an equi-distance apart.

The link portion may be configured so that part including a root portion linked to the support portion may be covered with the insulating layer together with the support portion.

### BRIEF DESCRIPTION OF THE DRAWINGS

Fig. 1 is an enlarged plan view of an essential portion showing a terminal structure according to the present invention.
Fig. 2 is an enlarged sectional view in a 2-2 line of Fig. 1.
Fig.3 is an enlarged sectional view in a 3-3 line of Fig. 1.
Fig. 4 is an enlarged plan view of an essential portion showing a state before a ball is soldered in the terminal structure according to the invention.
Fig. 5 is an enlarged plan view of an essential portion showing a first existing example of an existing terminal structure.
Fig. 6 is an enlarged sectional view in a 6-6 line of Fig. 5.
Fig. 7 is an enlarged plan view of an essential portion showing a second existing example of the existing terminal structure.
Fig. 8 is an enlarged sectional view in an 8-8 line of Fig. 7.

### DETAILED DESCRIPTION OF EMBODIMENTS OF THE INVENTION

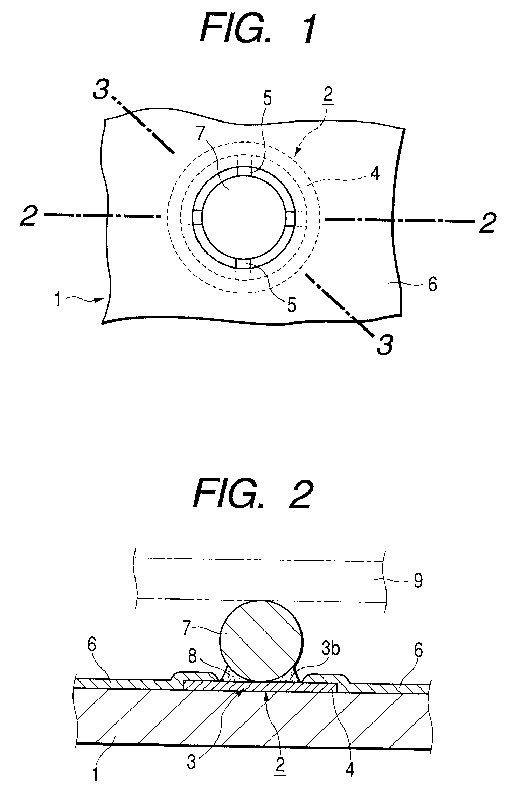

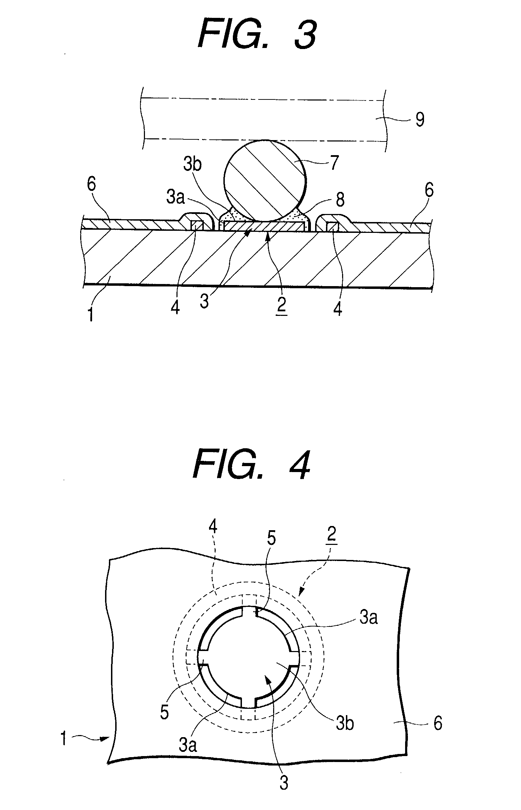

Drawings of a terminal structure of the invention will be explained. Fig. 1 is an enlarged plan view of an essential portion showing a terminal structure of the invention, Fig. 2 is an enlarged sectional view in a 2-2 line of Fig. 1, Fig. 3 is an enlarged sectional view in a 3-3 line of Fig.1, and Fig. 4 is an enlarged plan view of an essential portion showing a state before a ball is soldered in the terminal structure according to the invention.

In the next place, a configuration of a terminal structure of the invention will be explained with reference to Figs. 1 through 4. In a base material 1 made of a multi-layered substrate in which insulating thin plates are laminated or the like, not shown in the drawing, in a surface and inner layers thereof, a wiring pattern made of a conductive pattern is formed and various kinds of electric components are soldered to the wiring pattern, and thereby a desired electronic circuit is formed.

Furthermore, on one surface of the base material 1, a land portion 2 made of a conductive pattern is disposed, and the land portion 2 includes a circular terminal portion 3, a circular ring-like support portion 4 disposed so as to surround the neighborhood of the outer periphery portion of the terminal portion 3, and a plurality of link portions 5 that links between the terminal portion 3 and the support portion 4 and is disposed an equi-distance apart.

The terminal portion 3 of the land portion 2 is configured so as to connect through a connection conductor such as a through hole (not shown in the drawing) to the wiring pattern.

Furthermore, on one surface of the base material 1, an insulating layer 6 made of insulating resist is disposed, and with an entire surface 3b including an edge portion 3a located at the outer periphery portion of the terminal portion 3 exposed from the insulating layer 6, the insulating layer 6 covers an entire support portion 4 and part of the link portion 5 including the root portion connected to the support portion 4.

The metallic ball 7 for use in the terminal has a solder film (not shown in the drawing) on a surface thereof, and the ball 7, in a state disposed on the exposed terminal portion 3, is attached to the terminal portion 3 with the solder 8.

At this time, the solder 8 is adhered to the edge portion 3a and the surface 3b of the terminal portion 3.

The terminal structure having such configuration is configured so that, as shown in Figs. 2 and 3, on the ball 7, a member to be connected 9 made of a mother board or IC components and so on is disposed and soldered to the ball 7, and thereby an electrical connection is established.

In the terminal structure having such configuration, when by applying an external force on the ball 7, the peel test of the ball 7 is performed, since the solder 8 is stuck to the edge portion 3a and the surface 3b of the terminal portion 3, adherence between the terminal portion 3 and the ball 7 due to the solder 8 is strong, and a result that the ball 7 and the solder 8 become difficult to peel off the terminal portion 3 is obtained.

Furthermore, a result is obtained that since the link portion 5 linked to the terminal portion 3 is connected to the support portion 4 supported by the insulating layer 6, the terminal portion 3, supported by the link portion 5, becomes strong in the peel strength from the base material 1 thereof and difficult to peel.

In the terminal portion of the land portion in the embodiment, other than a circular shape, polygonal ones such as a square shape or the like may be used, and also in the support portion of the land portion, other than a circular shape, ring-like one having a polygonal shape may be used.

Furthermore, the link portion of the land portion may be allowed to dispose one, or two or more.

The terminal structure according to the invention includes a base material having a land portion made of a conductive pattern; and a metallic ball that is used for a terminal and soldered onto the land portion; wherein the land portion includes a terminal portion for soldering the ball; a support portion disposed in the neighborhood of an outer periphery portion of the terminal portion; and a link portion for linking the terminal portion and the support portion; and wherein on the base material, with an entirety of the terminal portion including an edge portion located in the outer periphery of the terminal portion exposed, an insulating layer is disposed so as to cover the support portion; and with a solder straddled over a surface and the edge portion of the terminal portion, the ball is soldered to the terminal portion. Accordingly, the terminal structure that is large in the peel strength of the ball off the terminal portion and of the terminal portion off the base material can be obtained.

Furthermore, since a plurality of link portions is disposed in the outer periphery portion of the link portion, the peel strength when the terminal portion is peeled off the base material can be made further stronger.

Still furthermore, since the support portion is disposed so as to surround the outer periphery portion of the terminal portion, the terminal structure strong in the support of the support portion due to the insulating layer can be obtained.

Furthermore, since a plurality of link portions is disposed an equi-distance apart, the terminal structure further stronger in the peel strength of the terminal portion off the base material can be obtained.

Still furthermore, since in the link portion, part including a root portion linked to the support portion, together with the support portion, is covered with the insulating layer, the support of the terminal portion due to the link portion becomes excellent, resulting in the further larger peel strength of the terminal structure off the base material.

## Claims

1. A terminal structure including a base material having a land portion made of a conductive pattern; and a metallic ball that is used for a terminal and soldered onto the land portion; wherein the land portion includes a terminal portion for soldering the ball; a support portion disposed in the neighborhood of an outer periphery portion of the terminal portion; and a link portion for linking the terminal portion and the support portion; and wherein on the base material, with an entirety of the terminal portion including an edge portion located at the outer periphery portion of the terminal portion exposed, an insulating layer is disposed so as to cover the support portion; and with the solder straddled a surface and the edge portion of the terminal portion, the ball is soldered to the terminal portion.

2. A terminal structure as claimed forth in claim 1:
wherein the link portion is disposed plurally in the outer periphery portion of the terminal portion.

3. A terminal structure as claimed in claim 1 or 2:
wherein the support portion is disposed so as to surround the outer periphery portion of the terminal portion.

4. A terminal structure as claimed in any preceding claim :
wherein a plurality of the link portions is disposed an equi-distance apart.

5. A terminal structure as claimed in any preceding claim;
wherein in the link portion, part including a root portion linked to the support portion, together with the support portion, is covered with the insulating layer.
